# EUROPEAN PATENT SPECIFICATION

(11) **EP 0 350 258 B1**
(45) Date of publication and mention of the grant of the patent: **13.04.1994**
(21) Application number: 89306778.5
(22) Date of filing: 04.07.1989
(51) Int. Cl.: B41J 2/295

(54) **Dot matrix printing heads**
Punktmatrixdruckköpfe
Têtes d'impression matricielles par points

(30) Priority: 08.07.1988 JP 168894/88; 11.11.1988 JP 283897/88
(43) Date of publication of application: 10.01.1990
(60) Divisional application: 93115068.4
(73) Proprietor: FUJITSU LIMITED, Kawasaki-shi, Kanagawa 211 (JP)
(72) Inventor: Yano, Akio, Tokyo 157 (JP)
(74) Representative: Fenlon, Christine Lesley

(56) References cited:
- US-A- 4 362 407
- PATENT ABSTRACTS OF JAPAN vol. 8, no. 104 (M-296)(1541) 16 May 1984; JP-A-59 16767
- PATENT ABSTRACTS OF JAPAN vol. 9, no. 245 (M-418)(1968) 02 October 1985; JP-A-60 97864
- PATENT ABSTRACTS OF JAPAN vol. 8, no. 284 (M-348)(1721) 26 December 1984; JP-A-59 152872
- PATENT ABSTRACTS OF JAPAN vol. 10, no. 372 (M-544)(2429) 11 December 1986; JP-A-61 164852

## Description

This invention relates to dot matrix printing heads.

Recently, high-speed wire-dot printing heads have become more widely used, and accordingly, to drive the dot-impact wires or rods of such high speed printing head, actuators comprising electro or magnetic-distortion devices have been developed and used instead of electromagnet type drive elements.

The use of such electro-distortion devices in a printing head has been proposed in "NIKKEI (Japan Economic) MECHANICAL", page 92, March 12, 1984, for example, the proposed electro-distortion device being made by the steps of: preparing a plurality of green sheets made of piezo-electric ceramics, forming a metal paste film on one of the surfaces of each of the green sheets to form an inner electrode, and laminating and sintering the plurality of green sheets.

A printing head using such an actuating device must be provided with means for effectively enlarging the very small displacements of such an actuating element so as to drive the dot-impact wires or rods adequately.

A dot-matrix printing head may include an array of dot-printing devices operable selectively to cause respective dot-defining portions thereof to impinge on a printing medium to cause respective dots to be printed. JP-A-59-16767 proposes a dot-printing device, suitable for use in such a dot-matrix printing head to achieve such enlargement, which device may be considered to comprise a flexible member, fixed at one end thereof to a support structure of the head and having at its other end the said dot-defining portion of the device, and also to comprise an electrically controllable actuator operable to impose movement on the flexible member, substantially perpendicularly to the main plane of that member, at an actuating position thereon as to bring about such impingement of the dot-defining portion of the device, the flexible member being laminar in form, at least in the region between the said one end and the actuating position, and the distance of the said actuating portion from the said one end of the flexible member of the device being small in comparison with the distance of the actuating position from the said dot-defining portion of the device.

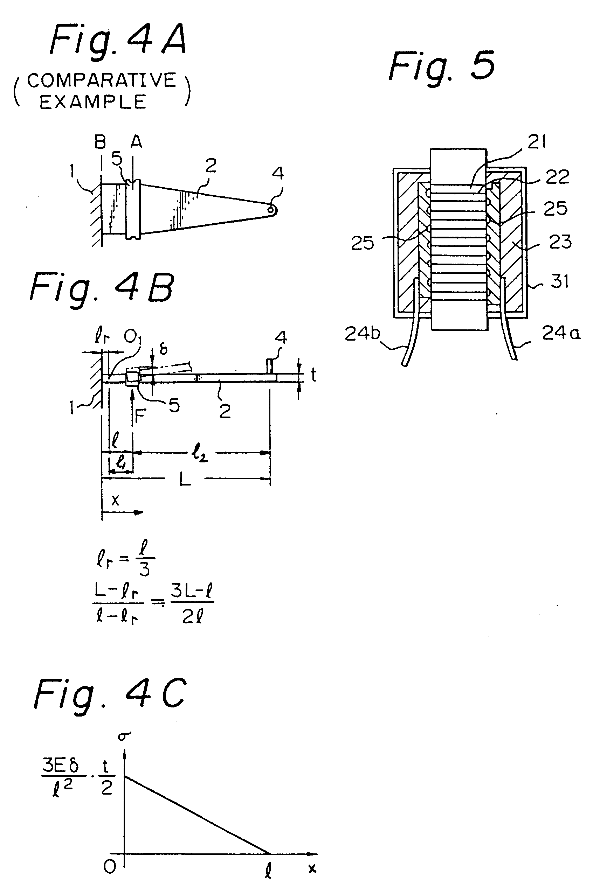

In this prior dot-printing device, however, the width of the said region, between the said one (fixed) end and the actuating position, is substantially constant, with the result (as discussed below with reference to Figure 4A of the accompanying drawings) that the factor by which the displacement of the actuating position is enlarged may not be satisfactory.

According to a first aspect of the present invention there is provided a dot-matrix printing head including an array of dot-printing devices operable selectively to cause respective dot-defining portions thereof to impinge on a printing medium to cause respective dots to be printed, each of which devices comprises a flexible member, fixed at one end thereof to a support structure of the head and having at its other end the said dot-defining portion of the device, and also comprises an electrically controllable actuator operable to impose movement on the flexible member, substantially perpendicularly to the main plane of that member, at an actuating position thereon as to bring about such impingement of the dot-defining portion of the device, the flexible member being laminar in form, at least in the region between the said one end and the actuating position, and the distance of the said actuating portion from the said one end of the flexible member of the device being small in comparison with the distance of the actuating position from the said dot-defining portion of the device; characterised in that the width of the said region increases progressively in the direction from the said actuating position to the said one end.

According to a second aspect of the present invention there is provided a dot-matrix printing head including an array of dot-printing devices operable selectively to cause respective dot-defining portions thereof to impinge on a printing medium to cause respective dots to be printed, each of which devices comprises a flexible member, fixed at one end thereof to a support structure of the head and having at its other end the said dot-defining portion of the device, and also comprises an electrically controllable actuator to impose movement on the flexible member, substantially perpendicularly to the main plane of that member, at an actuating position thereon as to bring about such impingement of the dot-defining portion of the device, the flexible member being laminar in form, at least in the region between the said one end and the actuating position, and the distance of the said actuating portion from the said one end of the flexible member of the device being small in comparison with the distance of the actuating position from the said dot-defining portion of the device; characterised in that the said region is formed with an aperture, extending from the said actuating position towards the said one end, between two lateral portions of the said region, each of which portions increases progressively in width in the direction from the said actuating position to the said one end.

In a preferred embodiment of the invention the flexible member is shaped substantially, in the said region thereof between the actuating position and the said one end, as one or more triangles, such that the base of each of the triangles is substantially located at the said one end and the apex thereof is substantially located at the actuating position.

In an embodiment of the present invention the said actuator is a piezo actuator which uses an electro-distortion device comprising: a plurality of sheets made of an electro-distortion material and laminated via electrodes, an insulation material enveloping the plurality of sheets and electrodes, a metal cover enveloping the insulation material, and means for applying an electric voltage between the adjacent electrodes, so that the device generates a strain or displacement in a direction of lamination of the plurality of sheets when such a voltage is applied between the adjacent electrodes.

Reference will now be made, by way of example, to the accompanying drawings, in which:
Figure 1 shows a partial perspective view of a printing head, including respective actuators for driving dot-impact wires or rods of a printer, embodying the aforesaid first and second aspects of the present invention;
Figures 2A and 2B show a plan view and a side elevation respectively of a printing device used in the printing head of Figure 1;
Figures 3A and 3B show respective plan and side elevational views of part of a component of the device shown in Figure 2;
Figure 3C is a graph of stress distribution along part of the component shown in Figures 3A and 3B;
Figures 4A, 4B and 4C are diagrams corresponding respectively to Figures 3A, 3B and 3C but relating, for comparison purposes, to a device in which the said component is of a different form; and
Figure 5 shows a longitudinal sectional view of an electro-distortion device suitable for use in the printing head of Figure 1.

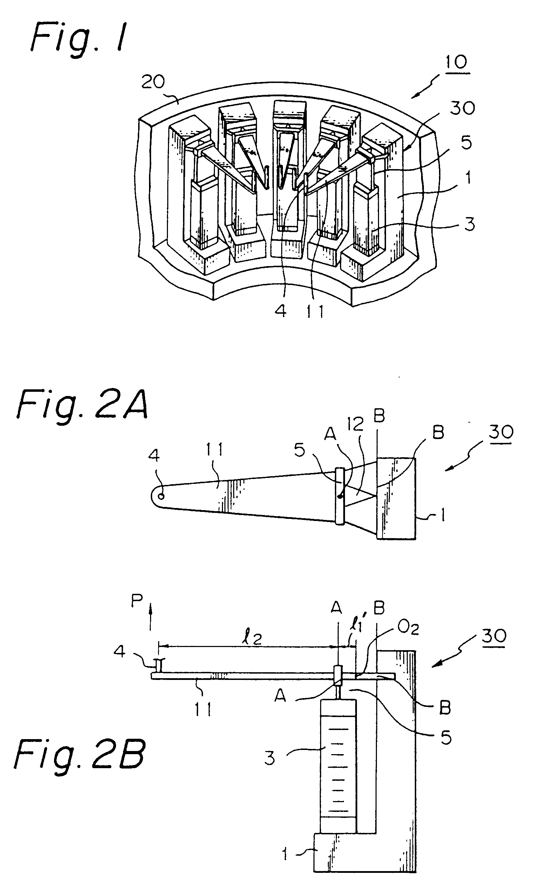

Figure 1 shows a printing head 10 of a dot-impact printer, comprising a cylindrical housing 20 and a plurality of printing devices 30 arrayed around and extending radially within the cylindrical housing 20.

As shown in more detail in Figures 2A and 2B, each of the devices 30 comprises a base member 1, a movable member 11, and an actuator (electro-distortion device) 3. The movable member 11 comprises a flat leaf spring made of an appropriate resilient material having one end rigidly secured to the base member 1 at a fixing position B and a free remote end on which a dot-printing member (dot-printing pin or wire) 4 is mounted. A predetermined number of such dot-printing members 4 cooperate to constitute a dot matrix. As may be seen in the plan view of Figure 2A, the movable member 11 is gradually tapered, along substantially its entire length, from the fixing portion B to the free end thereof.

The actuator 3 has one end rigidly secured to the base member 1 and the other end connected via a connecting member 5 to the movable member 11 at an actuating position A thereof. The actuating position A is relatively near to the position B at which the movable member 11 is fixed to the base member 1.

As seen in the plan view of Figure 2A, the region of the laminar movable member 11 that extends from the actuating position A to the fixing position B comprises two substantially triangular portions arranged laterally adjacent to one another, each of the portions having a base at the fixing position B and a truncated apex at the actuating position A. These two lateral portions are separated, as seen in the plan view, by a triangular-form aperture 12, having a base at the actuating position A and an apex at the fixing position B or in the vicinity thereof. In general, at least one such triangular-form aperture is desirable. As shown in the plan view of Figure 2A, the remaining part of the movable member 11 is gradually tapered from the actuating position A to the free end thereof.

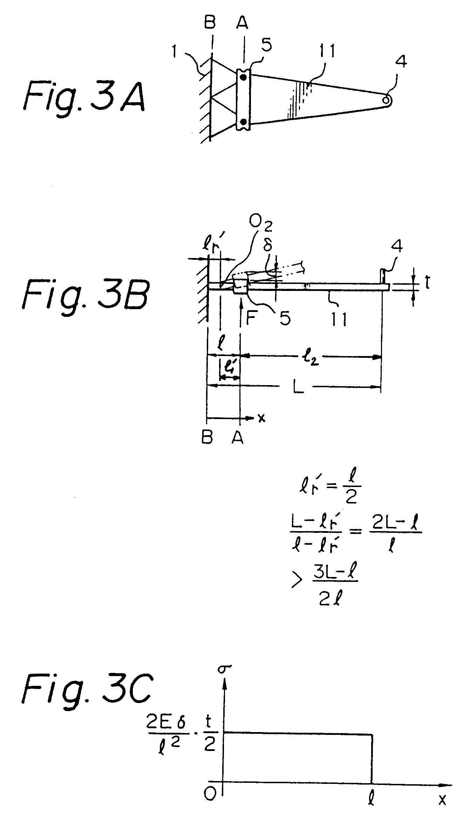

When printing, electric power is supplied via a drive circuit (not shown) to the actuator 3 for a predetermined time. This causes the actuator 3 to be distorted in the upward direction (i.e. perpendicular to the flat movable member 11), thereby upwardly displacing the movable member 11 at the actuating position A. The movable member 11 is thus resiliently deformed between the actuating position A and the fixing position B, so that the movable member 11 is bent in the clockwise direction in Figure 2B (in the counterclockwise direction in Figure 3B as shown by a dotted line) about the center (O₂) of rotation near to the fixing position B, as shown in Figures 3A and 3B. Owing to this movement of the movable member 11, the dot-printing member 4 is moved upward as shown by an arrow P in Figure 2B to perform a printing operation. The electric power supply to the actuator 3 is stopped just before the completion of the printing operation, and thus, after completion of printing, the movable member 2 is returned to the original position by the actuator 3.

Operation of the printing device of Figures 2 will now be described with reference to Figures 3A, 3B and 3C, and compared with corresponding operation of a printing device including a movable member 2, as shown in Figures 4A and 4B, not having the triangular aperture 12.

The width of the movable member 2 of the comparative example, as shown in the plan view of Figure 4A, is substantially constant from the fixing position B to the actuating position A, and is gradually reduced from the actuating position A to the free remote end on which the dot-printing member 4 is rigidly mounted.

In the movable member 2 of Figure 4A there is a tendency for the distribution of stress to be such that the point of maximum stress is located in the vicinity of the fixing position B when the movable member 2 is resiliently deformed, because the width of the movable member 2 is substantially constant from the fixing position B to the actuating position A. Thus, center of rotation O₁ of the movable member 2 tends to be located in the vicinity of the fixing position B, so that the factor by which the displacement of the position A is enlarged can be defined as: 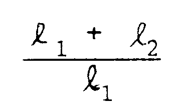
where ℓ₁ is the distance between the actuating position A and the center of rotation O₁, and ℓ₂ is the distance between the actuating position A and the free end of the movable member.

Therefore, if the length of the movable member 2 is shortened, to speed up the printing operation, the enlargement factor cannot be increased to a satisfactory level.

However, since the movable member 11 of Figures 2 and 3 has a triangular aperture 12 as mentioned above, the distortion mode in the movable member 11 is different from that of the member 2 of Figure 4A in that the angle through which the movable member 11 distorts at the actuating portion when resiliently deformed is greater than that of the member 2. This means that the distribution of stress is changed and the center of rotation O₂ of the movable member 11 is shifted toward the actuation position A, and thus an increased enlargement factor, defined as follows, is obtained: 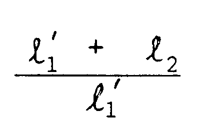
where ℓ_{1'} is the distance between the actuating position A and the center of rotation O₂.

Therefore, even if the movable member 11 is made shorter than the member 2, to speed up the printing operation, a satisfactory enlargement factor can still be obtained, by virtue of the fact that ℓ_{1'} < ℓ₁, thereby maintaining a sufficient displacement or stroke of the printing member 4 required for printing.

In Figures 3A, 3B and 3C and Figures 4A, 4B and 4C, the symbols ℓᵣ, ℓ_{r'}, δ, ℓ, L, and t are defined as follows:
ℓᵣ : distance from the fixing position B to the center of rotation O₁
ℓ_{r'} : distance from the fixing position B to the center of rotation O₂
δ : imposed displacement of the movable member at the actuating position A
ℓ : distance from the fixing position B to the actuating position A
L : total length of the movable member, and
t : thickness of the movable member.

As shown in Figures 3B and 4B of the drawings, the position of the center of rotation and the enlargement factor in the printing devices of Figures 3 and 4 respectively, are given, by way of example, in the following table:

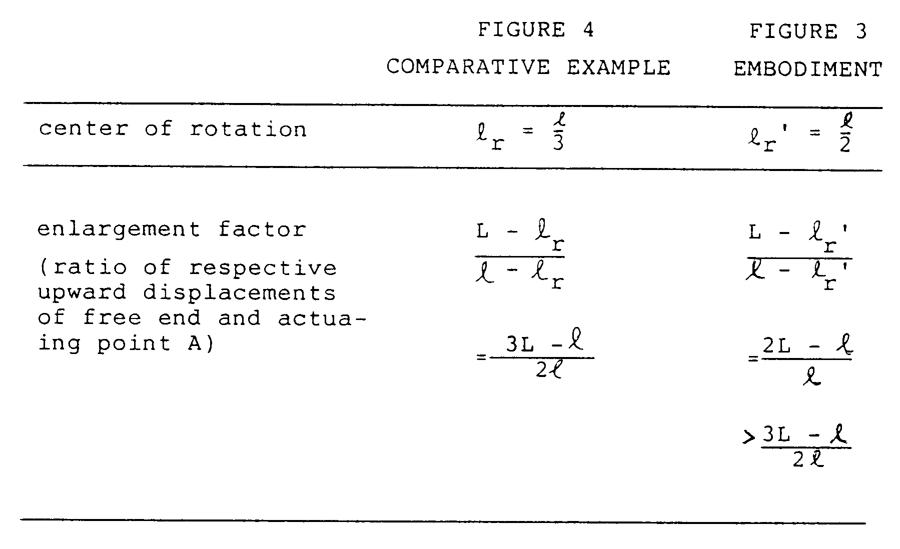

As can be appreciated from the above description, in the printing device of Figures 2A and 2B, the center of rotation O₂ of the movable member 11 is shifted toward the actuating position A, and thus the enlargement factor of the displacement at A is increased. The distribution of stress in the movable member 2 of Figures 4A and 4B can be represented as shown in Figure 4C by a straight line passing through σ = 0 at the actuating position A and 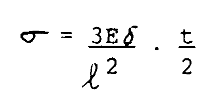
at the fixing position B. With the movable member formed as in Figure 3A, however, as shown in Figure 3C, the distribution of stress is substantially uniform between the fixing position B and the actuating position A, the magnitude of the stress being defined by the relation 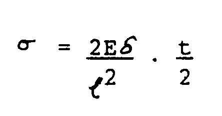
which is smaller than the maximum stress shown in Figure 4C.

Thus, an embodiment of the present invention can provide a high speed reliable printing head wherein the printing members are provided with sufficient stroke length and the distribution of stress is substantially uniform.

Figure 5 illustrates an electro-distortion device suitable for use as an actuator for driving a dot-impact printing wire or rod in the printing head of Figure 1. This electro-distortion device comprises a plurality of sheets 21 made of an electro-distortion material, such as a piezo-electric ceramic, and stacked together with laminar electrodes 22 therebetween. A first group of alternately arranged electrodes 22 are connected to a lead 24a and insulated from the other electrodes 22 by beads 25 made of an electrically insulating material, such as glass. The other group of alternate electrodes 22 are connected to a second lead 24b and insulated from the first group of electrodes 22 in the same manner as above. The laminations comprising the sheets of electro-distortion material 21 and the electrodes 22 are enclosed within an insulating resin material 23, such as an epoxy resin.

In use of the device an operating voltage is applied between the leads 24a and 24b, causing longitudinal electrostrictive expansion or contraction of the stack of laminations, the top of that stack being connected to the resilient member 11 of Figure 2B, for example, and the bottom of the stack being fixed to or mounted on a lower part of the base member 1.

In the device of Figure 5, the insulating resin material 23 is itself also enveloped in a metal cover 31. This metal cover 31 can be formed by vaporizing an appropriate metal, such as aluminum, onto the insulating resin material 23, thus inhibiting the ingress of moisture into the electro-distortion device by virtue of the high moisture-proof characteristics of such a metal cover. The insulating resin material 23 prevents short-circuits between adjacent electrodes 22 that would otherwise be caused by the metal cover 31. As a result, the electrodes 22 are not prone to becoming electrically connected to each other due to migration effects for example, even if the device is used in a moist environment, so that the device has a desirably high inherent reliability.

## Claims

1. A dot-matrix printing head including an array of dot-printing devices (30) operable selectively to cause respective dot-defining portions (4) thereof to impinge on a printing medium to cause respective dots to be printed, each of which devices comprises a flexible member (11), fixed at one end thereof to a support structure (1) of the head and having at its other end the said dot-defining portion (4) of the device, and also comprises an electrically controllable actuator (3) operable to impose movement on the flexible member (11), substantially perpendicularly to the main plane of that member, at an actuating position (A) thereon as to bring about such impingement of the dot-defining portion (4) of the device, the flexible member (11) being laminar in form, at least in the region between the said one end and the actuating position (A), and the distance of the said actuating position (A) from the said one end of the flexible member of the device being small in comparison with the distance of the actuating position from the said dot-defining portion of the device;
characterised in that the width of the said region increases progressively in the direction from the said actuating position (A) to the said one end.

2. A dot-matrix printing head including an array of dot-printing devices (30) operable selectively to cause respective dot-defining portions (4) thereof to impinge on a printing medium to cause respective dots to be printed, each of which devices comprises a flexible member (11), fixed at one end thereof to a support structure (1) of the head and having at its other end the said dot-defining portion (4) of the device, and also comprises an electrically controllable actuator (3) operable to impose movement on the flexible member (11), substantially perpendicularly to the main plane of that member, at an actuating position (A) thereon as to bring about such impingement of the dot-defining portion (4) of the device, the flexible member (11) being laminar in form, at least in the region between the said one end and the actuating position (A), and the distance of the said actuating position (A) from the said one end of the flexible member of the device being small in comparison with the distance of the actuating position from the said dot-defining portion of the device;
characterised in that the said region is formed with an aperture (12), extending from the said actuating position (A) towards the said one end, between two lateral portions of the said region, each of which portions increases progressively in width in the direction from the said actuating position (A) to the said one end.

3. A dot-matrix printing head as claimed in claim 2, wherein the said aperture (12) narrows progressively in the said direction.

4. A dot-matrix printing head as claimed in claim 2 or 3, wherein in each of the said devices the opposite outermost edges of the said region diverge from one another in the said direction.

5. A dot-matrix printing head as claimed in any preceding claim, wherein in each of the said devices the said flexible member (11) decreases progressively in width from the said actuating position (A) to the said other end.

6. A dot-matrix printing head as claimed in any preceding claim, wherein the said actuator (3) of each dot-printing device has one end fixed to or mounted on the said support structure (1) and an opposite end connected to the said flexible member (11) of the device concerned at the actuating position (A) of that member.

7. A dot-matrix printing head as claimed in any preceding claim, wherein each said actuator (3) comprises an electro-distortion device.

8. A dot-matrix printing head as claimed in claim 7, wherein the said electro-distortion device comprises a stack of laminations (21) made of an electro-distortion material with respective electrodes (22) included at different positions in the stack, each of which electrodes is sandwiched between two successive laminations of the electro-distortion material, insulating material (23) surrounding the said stack, and externally accessible connection means whereby an electrical potential can be applied between successive electrodes in the stack, thereby to bring about a change in the extent of the stack along its stacking axis.

9. A dot-matrix printing head as claimed in claim 8, wherein the said insulating material (23) is enveloped by a metal cover (31).

10. A dot-matrix printing head as claimed in claim 9, wherein the said metal cover (31) has been formed by vaporising the metal onto the said insulating material (23).

11. A dot-matrix printing head as claimed in claim 9 or 10, wherein the said metal cover (31) is made of aluminium.

12. A dot-matrix printing head as claimed in claim 8, 9, 10 or 11, wherein the said electro-distortion material is a piezo-electric ceramic.

## Patentansprüche

1. Ein Punktmatrixdruckkopf mit einem Feld von Punktdruckanordnungen (30), die selektiv betriebsfähig sind, um zu bewirken, daß jeweilige punktdefinierende Abschnitte (4) von ihnen auf einem Druckmedium auftreffen, um das Drucken von entsprechenden Punkten zu bewirken, wobei jede der Anordnungen ein flexibles Glied (11) umfaßt, das an seinem einen Ende an einer Stützstruktur (1) des Kopfes befestigt ist und an seinem anderen Ende den genannten punktdefinierenden Abschnitt (4) der Anordnung hat, und ferner einen elektrisch steuerbaren Betätiger (3) umfaßt, der betriebsfähig ist, um dem flexiblen Glied (11) eine Bewegung im wesentlichen senkrecht zu der Hauptebene jenes Gliedes an einer Betätigungsposition (A) an ihm aufzuzwingen, um solch ein Auftreffen des punktdefinierenden Abschnittes (4) der Anordnung zu bewirken, wobei das flexible Glied (11) in der Form laminar ist, wenigstens in der Zone zwischen dem genannten einen Ende und der Betätigungsposition (A), und wobei der Abstand der genannten Betätigungsposition (A) von dem genannten einen Ende des flexiblen Gliedes der Anordnung im Vergleich zu dem Abstand der Betätigungsposition von dem genannten punktdefinierenden Abschnitt der Anordnung klein ist;
dadurch gekennzeichnet, daß die Breite der genannten Zone in der Richtung von der genannten Betätigungsposition (A) zu dem genannten einen Ende progressiv größer wird.

2. Ein Punktmatrixdruckkopf mit einem Feld von Punktdruckanordnungen (30), die selektiv betriebsfähig sind, um zu bewirken, daß jeweilige punktdefinierende Abschnitte (4) von ihnen auf einem Druckmedium auftreffen, um das Drucken von entsprechenden Punkten zu bewirken, wobei jede der Anordnungen ein flexibles Glied (11) umfaßt, das an seinem einen Ende an einer Stützstruktur (1) des Kopfes befestigt ist und an seinem anderen Ende den genannten punktdefinierenden Abschnitt (4) der Anordnung hat, und ferner einen elektrisch steuerbaren Betätiger (3) umfaßt, der betriebsfähig ist, um dem flexiblen Glied (11) eine Bewegung im wesentlichen senkrecht zu der Hauptebene jenes Gliedes an einer Betätigungsposition (A) an ihm aufzuzwingen, um solch ein Auftreffen des punktdefinierenden Abschnittes (4) der Anordnung zu bewirken, wobei das flexible Glied (11) in der Form laminar ist, wenigstens in der Zone zwischen dem genannten einen Ende und der Betätigungsposition (A), und wobei der Abstand der genannten Betätigungsposition (A) von dem genannten einen Ende des flexiblen Gliedes der Anordnung im Vergleich zu dem Abstand der Betätigungsposition von dem genannten punktdefinierenden Abschnitt der Anordnung klein ist;
dadurch gekennzeichnet, daß die genannte Zone mit einer Apertur (12) gebildet ist, die sich von der genannten Betätigungsposition (A) zu dem genannten einen Ende hin erstreckt, zwischen zwei seitlichen Abschnitten der genannten Zone, wobei jeder der Abschnitte in der Richtung von der genannten Betätigungsposition (A) zu dem genannten einen Ende in der Breite progressiv größer wird.

3. Ein Punktmatrixdruckkopf nach Anspruch 2, bei dem die genannte Apertur (12) in der genannten Richtung progressiv schmaler wird.

4. Ein Punktmatrixdruckkopf nach Anspruch 2 oder 3, bei dem bei jeder der genannten Anordnungen die gegenüberliegenden äußersten Ränder der genannten Zone in der genannten Richtung voneinander divergieren.

5. Ein Punktmatrixdruckkopf nach irgendeinem vorhergehenden Anspruch, bei dem bei jeder der genannten Anordnungen das flexible Glied (11) von der genannten Betätigungsposition (A) zu dem genannten anderen Ende in der Breite progressiv abnimmt.

6. Ein Punktmatrixdruckkopf nach irgendeinem vorhergehenden Anspruch, bei dem der genannte Betätiger (3) von jeder Punktdruckanordnung ein Ende hat, das an der genannten Stützstruktur (1) befestigt oder montiert ist, und ein gegenüberliegendes Ende, das mit dem genannten flexiblen Glied (11) der betreffenden Anordnung an der Betätigungsposition (A) jenes Gliedes verbunden ist.

7. Ein Punktmatrixdruckkopf nach irgendeinem vorhergehenden Anspruch, bei dem jeder genannte Betätiger (3) eine Elektroverformungsanordnung umfaßt.

8. Ein Punktmatrixdruckkopf nach Anspruch 7, bei dem die genannte Elektroverformungsanordnung einen Stapel von Laminierungen (21) umfaßt, die aus einem Elektroverformungsmaterial mit entsprechenden Elektroden (22) bestehen, die an verschiedenen Position in dem Stapel enthalten sind, jede der Elektroden zwischen zwei aufeinanderfolgenden Laminierungen des Elektroverformungsmaterials angeordnet ist, wobei Isoliermaterial (23) den genannten Stapel umgibt, und extern zugängliche Verbindungsmittel, wodurch ein elektrisches Potential zwischen aufeinanderfolgenden Elektroden in dem Stapel angelegt werden kann, um dadurch eine Veränderung des Ausmaßes des Stapels längs seiner Stapelachse zu bewirken.

9. Ein Punktmatrixdruckkopf nach Anspruch 8, bei dem das genannte Isoliermaterial (23) von einem Metallüberzug (31) umgeben ist.

10. Ein Punktmatrixdruckkopf nach Anspruch 9, bei dem der genannte Metallüberzug (31) durch Verdampfen des Metalls auf das genannten Isoliermaterial (23) gebildet wurde.

11. Ein Punktmatrixdruckkopf nach Anspruch 9 oder 10, bei dem der genannte Metallüberzug (31) aus Aluminium hergestellt ist.

12. Ein Punktmatrixdruckkopf nach Anspruch 8, 9, 10 oder 11, bei dem das genannte Elektroverformungsmaterial eine piezoelektrische Keramik ist.

## Revendications

1. Tête d'impression par points, comprenant un groupe de dispositifs (30) d'impression de point qui peuvent fonctionner sélectivement et qui provoquent la frappe de leur partie respective (4) de formation de point sur un support d'impression de manière que les points respectifs soient imprimés, chacun des dispositifs comprenant un organe flexible (11) fixé à une première extrémité à une structure (1) de support de la tête et ayant, à l'autre extrémité, la partie (4) de formation de point du dispositif, et comprenant aussi un organe (3) de manoeuvre qui peut être commandé électriquement et qui est destiné à imposer un déplacement de l'organe flexible (11) en direction sensiblement perpendiculaire au plan principal de cet organe, à une position de manoeuvre (A) de cet organe qui est telle que la frappe de la partie (4) de formation de point du dispositif est assurée, l'organe flexible (11) ayant une forme plate, au moins dans la région comprise entre la première extrémité et la position de manoeuvre (A), la distance comprise entre la position de manoeuvre (A) et la première extrémité de l'organe flexible du dispositif étant faible par rapport à la distance comprise entre la position de manoeuvre et la partie de formation de point du dispositif,
caractérisée en ce que la largeur de ladite région augmente progressivement de la position de manoeuvre (A) vers ladite première extrémité.

2. Tête d'impression par points, comprenant un groupe de dispositifs (30) d'impression de point qui peuvent être commandés sélectivement afin qu'ils provoquent la frappe de leur partie respective (4) de formation de point sur un support d'impression et provoquent l'impression de points respectifs, chacun des dispositifs comprenant un organe flexible (11) fixé à une première extrémité sur une structure (1) de support de la tête et ayant, à son autre extrémité, la partie (4) de formation de point du dispositif, et comprenant en outre un organe de manoeuvre (3) qui peut être commandé électriquement et qui est destiné à imposer un déplacement de l'organe flexible (11) en direction sensiblement perpendiculaire au plan principal de cet organe, à une position de manoeuvre (A) formée sur cet organe qui est telle que la frappe de la partie (4) de formation de point du dispositif est assurée, l'organe flexible (11) ayant une forme plate, au moins dans la région comprise entre la première extrémité et la position de manoeuvre (A), et la distance de la position de manoeuvre (A) à la première extrémité de l'organe flexible du dispositif étant faible par rapport à la distance de la position de manoeuvre à la partie de formation de point du dispositif,
caractérisée en ce que ladite région est formée avec une ouverture (12) partant de la position de manoeuvre (A) vers la première extrémité, entre deux parties latérales de ladite région, chacune des parties ayant une largeur qui augmente progressivement de la position de manoeuvre (A) vers la première extrémité.

3. Tête d'impression par points selon la revendication 2, dans laquelle ladite ouverture (12) se rétrécit progressivement dans ladite direction.

4. Tête d'impression par points selon la revendication 2 ou 3, dans laquelle, dans chacun des dispositifs, les bords externes opposés de ladite région divergent l'un de l'autre dans ladite direction.

5. Tête d'impression par points selon l'une quelconque des revendications précédentes, dans laquelle, dans chacun des dispositifs, l'organe flexible (11) a une largeur qui diminue progressivement de la position de manoeuvre (A) vers l'autre extrémité.

6. Tête d'impression par points selon l'une quelconque des revendications précédentes, dans laquelle l'organe de manoeuvre (3) de chaque dispositif d'impression de point a une première extrémité fixée à la structure de support (1) ou montée sur celle-ci, et une extrémité opposée raccordée à l'organe flexible (11) du dispositif concerné à la position de manoeuvre (A) de cet organe.

7. Tête d'impression par points selon l'une quelconque des revendications précédentes, dans laquelle l'organe de manoeuvre (3) est un dispositif à distorsion électrique.

8. Tête d'impression par points selon la revendication 7, dans laquelle le dispositif à distorsion électrique comprend un empilement de couches (21) formées d'un matériau à distorsion électrique avec des électrodes respectives (22) incorporées à différentes positions dans la pile, chacune des électrodes étant entourée par deux couches successives du matériau à distorsion électrique, un matériau isolant (23) entourant la pile, et un dispositif de connexion accessible par l'extérieur de manière qu'un potentiel électrique puisse être appliqué entre les électrodes successives de la pile, si bien qu'un changement d'étendue de la pile suivant son axe d'empilement est assuré.

9. Tête d'impression par points selon la revendication 8, dans laquelle le matériau isolant (23) est enveloppé par un couvercle métallique (31).

10. Tête d'impression par points selon la revendication 9, dans laquelle le couvercle métallique (31) a été formé par vaporisation du métal sur le matériau isolant (23).

11. Tête d'impression par points selon la revendication 9 ou 10, dans laquelle le couvercle métallique (31) est formé d'aluminium.

12. Tête d'impression par points selon la revendication 8, 9, 10 ou 11, dans laquelle le matériau à distorsion électrique est une céramique piézoélectrique.
